# FASCICULE DE BREVET EUROPEEN

(11) **EP 2 537 757 B1**
(45) Date de publication et mention de la délivrance du brevet: **28.10.2015**
(21) Numéro de dépôt: 12172610.3
(22) Date de dépôt: 19.06.2012
(51) Int. Cl.: H01L 31/054, H01L 31/052, B64G 1/22, B64G 1/44

(54) **Ensemble hybride d'au moins un panneau solaire**
Hybridanlage mit mindestens einem Solarpaneel
Hybrid assembly of at least one solar panel

(30) Priorité: 23.06.2011 FR 1101933
(43) Date de publication de la demande: 26.12.2012
(73) Titulaire: Thales, 92200 Neuilly Sur Seine (FR)
(72) Inventeur: Boulanger, Bernard, 83600 Frejus (FR)
(74) Mandataire: Brunelli, Gérald

(56) Documents cités:
- WO-A1-2008/098279
- WO-A2-2007/041018
- US-A- 5 959 787
- US-A- 6 075 200

## Description

La présente invention porte sur un Ensemble hybride d'au moins un panneau solaire.

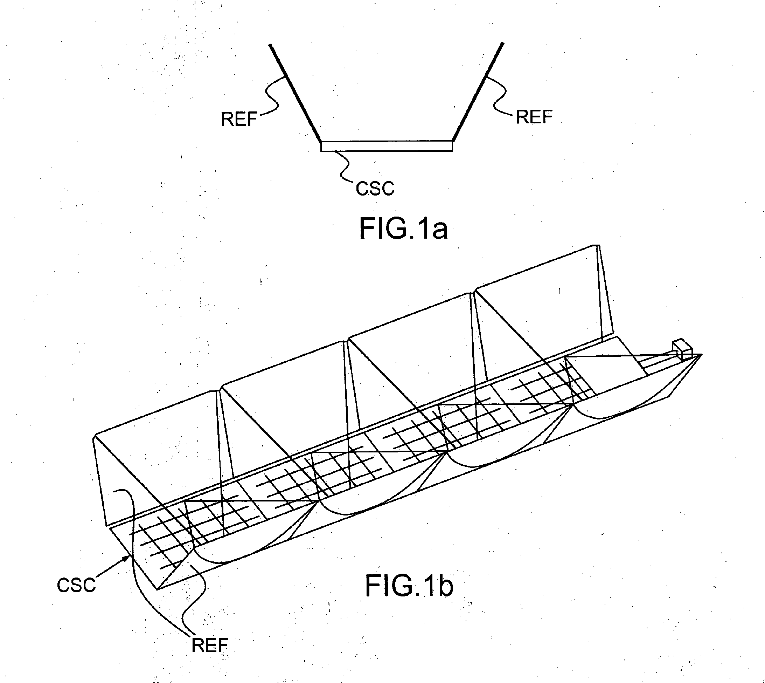

Il est connu l'utilisation de panneaux solaires réalisés avec des cellules solaires CSC munies de moyens de concentration Conc d'énergie lumineuse ou énergie solaire, tels des réflecteurs Ref comme illustrés sur les figures 1a et 1b. De tels systèmes ont été utilisés sur les satellites Boeing HS702.

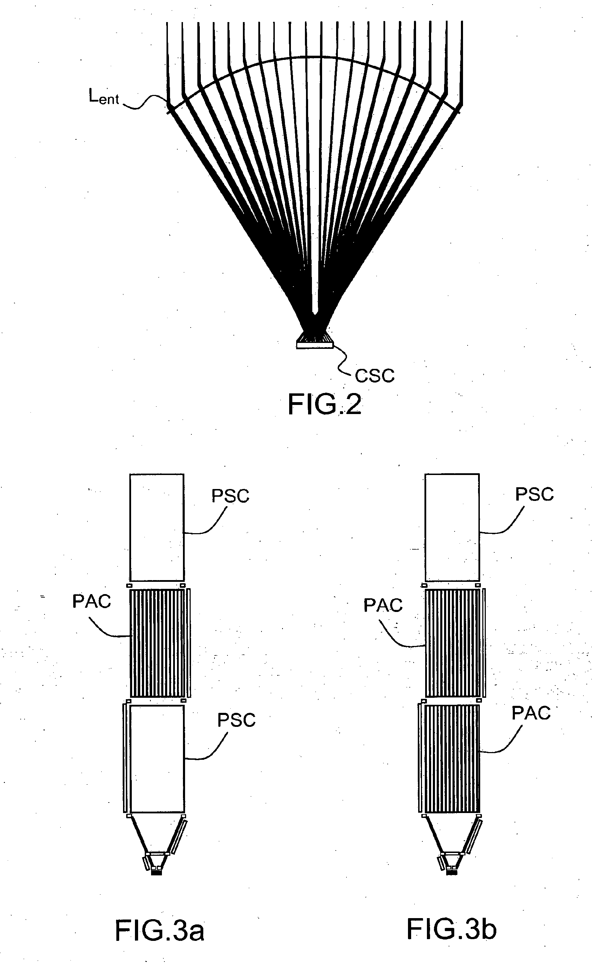

Il est également connu des panneaux solaires réalisés avec des cellules solaires CSC munies de moyens de concentration Conc d'énergie lumineuse, tels des concentrateurs réalisés au moyen de lentilles Lent comme dans des système SLA pour "Stretched Lens Array" en langue anglaise, comme illustré sur la figure 2. La lentille Lent concentre l'énergie lumineuse sur la cellule solaire CSC. De tels systèmes sont par exemple décrits dans les documents de brevet US 6188012 (Tecstar), WO 00/7959 (AEC-ABLE) ou WO 02/08058 (CSL), ou US 6075200 (ENTECH) qui est considéré comme l'art antérieur le plus proche et décrit les caractéristiques du préambule de la revendication 1.

L'utilisation de panneaux solaires à cellules solaires munies de moyens de concentration, pour des satellites, est connue, mais pose des problèmes, notamment lors d'un dépointage, durant lequel l'énergie électrique créée devient très faible, car ce type de cellules, a généralement un rendement énergétique relativement binaire selon le pointage ou le dépointage par rapport à la source d'énergie lumineuse.

On entend par dépointage, une déviation angulaire, entre la direction du faisceau d'énergie lumineuse émis par la source lumineuse, en l'espèce le soleil, et la face réceptrice de la cellule solaire.

Aussi, en cas de dépointage de panneaux solaires de satellites, notamment lors de phases de mise à poste d'un satellite, ou lorsqu'un satellite a perdu son attitude nominale, l'énergie électrique ou courant électrique fourni par le générateur solaire au satellite est très faible.

Un but de l'invention est notamment de pouvoir éviter les pertes très importantes d'énergie électrique délivrée, notamment lors d'un dépointage, par exemple lors de phases de mise à poste d'un satellite, ou lorsqu'un satellite a perdu son attitude nominale, l'énergie électrique ou courant électrique fourni par le générateur solaire au satellite étant alors très faible.

Une autre application de cette invention, peut concerner les engins spatiaux dont l'illumination solaire varie beaucoup pendant sa mission, et passe par exemple, d'une illumination standard en orbite terrestre à une faible illumination dans l'espace profond, où les systèmes à concentration sont bien adaptés.

Il est proposé, selon un aspect de l'invention, un engin spatial comprenant un ensemble hybride d'au moins un panneau solaire. L'ensemble comprend au moins une cellule solaire munie de moyens de concentration d'énergie lumineuse, et au moins une cellule solaire dépourvue de moyens de concentration d'énergie lumineuse.

Un tel engin spatial muni d'un tel ensemble hybride permet d'éviter les pertes très importantes d'énergie électrique délivrée, notamment lors d'un dépointage, par exemple lors de phases de mise à poste d'un satellite, ou lorsqu'un satellite a perdu son attitude nominale.

Selon un mode de réalisation, lesdits moyens de concentration d'énergie lumineuse comprennent au moins un réflecteur.

Les réflecteurs peuvent être partagés pour une pluralité de cellules solaires ou dédiés à une seule cellule solaire.

L'intérêt est de réduire le nombre de cellules qui sont très coûteuses, et ainsi de réduire le coût de ces systèmes.

Dans un mode de réalisation, lesdits moyens de concentration d'énergie lumineuse comprennent au moins un concentrateur.

L'utilisation de concentrateurs, comme des lentilles optiques, permet d'augmenter de manière importante l'énergie solaire transmise aux cellules solaires, et ainsi de manière importante l'énergie électrique délivrée par les cellules solaires, par exemple de l'ordre de dix fois plus que sans concentrateurs.

Le coût est ainsi réduit.

Par exemple, une telle lentille est une lentille de Fresnel et comprend au moins une partie en matériau souple pliable, et un dispositif de déploiement de ladite lentille.

Ainsi, il est possible de réduire le nombre de cellules très coûteuses, et le coût du système.

Selon un mode de réalisation, l'ensemble hybride comprend au moins un panneau solaire muni exclusivement de cellules solaires munies de moyens de concentration d'énergie lumineuse, et au moins un panneau solaire muni exclusivement de cellules solaires dépourvues de moyens de concentration d'énergie lumineuse.

Un tel mode de réalisation permet de limiter le coût de fabrication des panneaux solaires de l'ensemble hybride, car un panneau solaire comprend soit uniquement des cellules solaires munies de moyens de concentration d'énergie lumineuse, soit uniquement des cellules solaires dépourvues de moyens de concentration d'énergie lumineuse.

Selon un autre aspect de l'invention, il est également proposé un procédé de génération d'énergie électrique par hybridation d'énergie électrique générée par au moins une cellule solaire muni de moyens de concentration d'énergie lumineuse, et au moins une cellule solaire dépourvue de moyens de concentration d'énergie lumineuse.

L'invention sera mieux comprise à l'étude de quelques modes de réalisation décrits à titre d'exemples nullement limitatifs et illustrés par les dessins annexés sur lesquels
- les figures 1a et 1b illustrent schématiquement un panneau solaire réalisé avec des cellules solaires munies de réflecteurs, selon l'état de la technique ;
- la figure 2 illustre schématiquement une cellule solaire muni d'un concentrateur réalisé sous forme de lentille; et
- les figures 3a, 3b, 3c, 3d, 3e, 3f, 3g, 3h, 3i, 3j, 3k; 3l; 3m, 3n, 3o, 3p, 3q illustrent schématiquement un ensemble hybride comprend au moins un panneau solaire muni exclusivement de cellules solaires munies de moyens de concentration d'énergie lumineuse, et au moins un panneau solaire muni exclusivement de cellules solaires dépourvues de moyens de concentration d'énergie lumineuse.

Sur les différentes figures, les éléments ayant des références identiques sont similaires.

Les figures 3a à 3q illustrent des ailes de générateurs solaires de satellites, comprenant au moins un panneau solaire muni exclusivement de cellules solaires munies de moyens de concentration d'énergie lumineuse, et au moins un panneau solaire muni exclusivement de cellules solaires dépourvues de moyens de concentration d'énergie lumineuse. Bien entendu ces modes de réalisation ne sont pas limitatifs.

La figure 3a illustre une aile de générateur solaire GS munie de trois panneaux solaires agencés linéairement, dont un panneau PAC est muni exclusivement de cellules solaires munies de moyens de concentration d'énergie lumineuse, disposé entre deux autres panneaux solaires PSC muni exclusivement de cellules solaires dépourvues de moyens de concentration d'énergie lumineuse.

Durant une phase avec dépointage, une telle aile de générateur solaire fournit ainsi un tiers d'énergie électrique en moins, car le panneau solaire PAC muni exclusivement de cellules solaires munies de moyens de concentration d'énergie lumineuse ne fournit plus d'énergie électrique.

La figure 3b illustre une aile de générateur solaire GS munie de trois panneaux solaires agencés linéairement, dont deux panneau PAC sont munis exclusivement de cellules solaires munies de moyens de concentration d'énergie lumineuse, disposés de manière contiguë, du côté de l'aile attachée au satellite, et un panneau solaires PSC est muni exclusivement de cellules solaires dépourvues de moyens de concentration d'énergie lumineuse.

Durant une phase avec dépointage, une telle aile de générateur solaire fournit ainsi deux tiers d'énergie électrique en moins, car les deux panneaux solaires PAC muni exclusivement de cellules solaires munies de moyens de concentration d'énergie lumineuse ne fournissent plus d'énergie électrique.

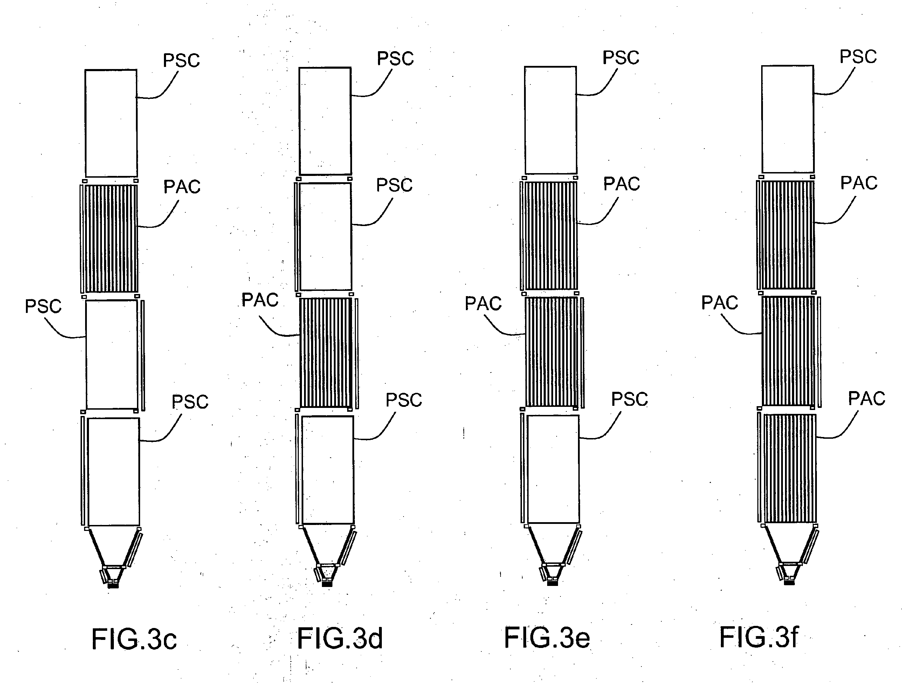

La figure 3c illustre une aile de générateur solaire GS munie de quatre panneaux solaires agencés linéairement, dont un panneau PAC est muni exclusivement de cellules solaires munies de moyens de concentration d'énergie lumineuse, disposé en troisième position en commençant à numéroter les positions du côté de l'aile attachée au satellite, et trois panneaux solaires PSC sont munis exclusivement de cellules solaires dépourvues de moyens de concentration d'énergie lumineuse.

Durant une phase avec dépointage, une telle aile de générateur solaire fournit ainsi un quart d'énergie électrique en moins, car le panneau solaire PAC muni exclusivement de cellules solaires munies de moyens de concentration d'énergie lumineuse ne fournit plus d'énergie électrique.

La figure 3d illustre une aile de générateur solaire GS munie de quatre panneaux solaires agencés linéairement, dont un panneau PAC est muni exclusivement de cellules solaires munies de moyens de concentration d'énergie lumineuse, disposé en deuxième position en commençant à numéroter les positions du côté de l'aile attachée au satellite, et trois panneaux solaires PSC sont munis exclusivement de cellules solaires dépourvues de moyens de concentration d'énergie lumineuse.

Durant une phase avec dépointage, une telle aile de générateur solaire fournit ainsi un quart d'énergie électrique en moins, car le panneau solaire PAC muni exclusivement de cellules solaires munies de moyens de concentration d'énergie lumineuse ne fournit plus d'énergie électrique.

La figure 3e illustre une aile de générateur solaire GS munie de quatre panneaux solaires agencés linéairement, dont deux panneaux PAC sont munis exclusivement de cellules solaires munies de moyens de concentration d'énergie lumineuse, disposés en deuxième et troisième positions, en commençant à numéroter les positions du côté de l'aile attachée au satellite, et deux panneaux solaires PSC sont munis exclusivement de cellules solaires dépourvues de moyens de concentration d'énergie lumineuse.

Durant une phase avec dépointage, une telle aile de générateur solaire fournit ainsi la moitié d'énergie électrique en moins, car les deux panneaux solaires PAC munis exclusivement de cellules solaires munies de moyens de concentration d'énergie lumineuse ne fournissent plus d'énergie électrique.

La figure 3f illustre une aile de générateur solaire GS munie de quatre panneaux solaires agencés linéairement, dont trois panneaux PAC sont munis exclusivement de cellules solaires munies de moyens de concentration d'énergie lumineuse, disposés en première, deuxième et troisième positions, en commençant à numéroter les positions du côté de l'aile attachée au satellite, et un panneau solaire PSC est muni exclusivement de cellules solaires dépourvues de moyens de concentration d'énergie lumineuse.

Durant une phase avec dépointage, une telle aile de générateur solaire fournit ainsi les trois quarts d'énergie électrique en moins, car les trois panneaux solaires PAC munis exclusivement de cellules solaires munies de moyens de concentration d'énergie lumineuse ne fournissent plus d'énergie électrique.

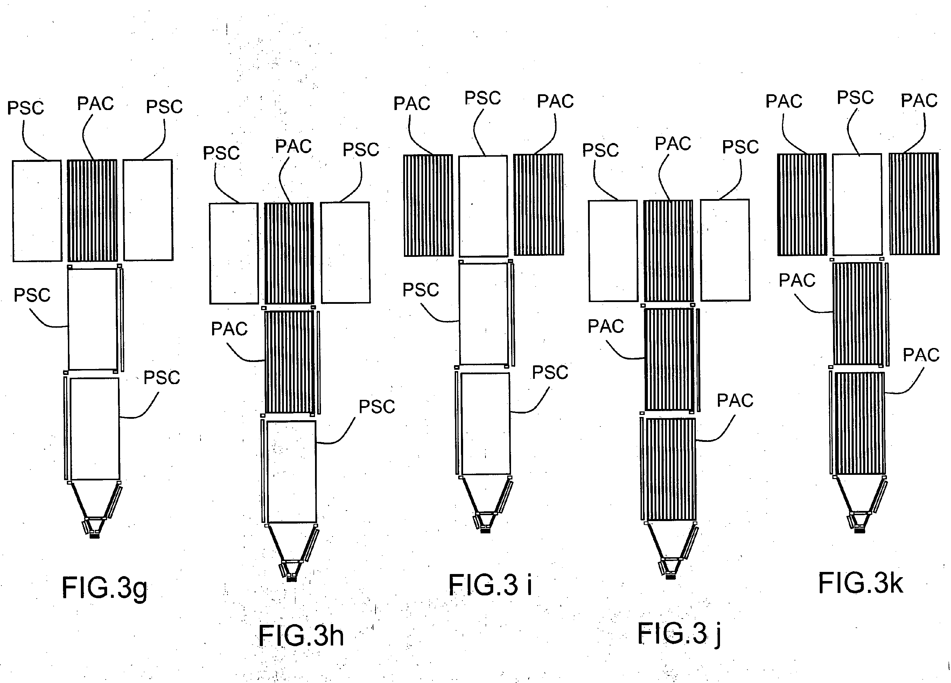

La figure 3g illustre une aile de générateur solaire GS munie de cinq panneaux solaires agencés en forme de T dont la base est du côté de l'aile attachée au satellite.

Un panneau PAC est muni exclusivement de cellules solaires munies de moyens de concentration d'énergie lumineuse, et est disposé au milieu de la barre horizontale du T.

Les quatre autres panneaux solaires PSC sont munis exclusivement de cellules solaires dépourvues de moyens de concentration d'énergie lumineuse.

Durant une phase avec dépointage, une telle aile de générateur solaire fournit ainsi un cinquième d'énergie électrique en moins, car le panneau solaire PAC muni exclusivement de cellules solaires munies de moyens de concentration d'énergie lumineuse ne fournit plus d'énergie électrique.

La figure 3h illustre une aile de générateur solaire GS munie de cinq panneaux solaires agencés en forme de T dont la base est du côté de l'aile attachée au satellite.

Deux panneaux PAC sont munis exclusivement de cellules solaires munies de moyens de concentration d'énergie lumineuse, et sont disposés au milieu de la barre horizontale du T et juste en dessous dans la barre verticale du T.

Les trois autres panneaux solaires PSC sont munis exclusivement de cellules solaires dépourvues de moyens de concentration d'énergie lumineuse.

Durant une phase avec dépointage, une telle aile de générateur solaire fournit ainsi deux cinquièmes d'énergie électrique en moins, car les deux panneaux solaires PAC munis exclusivement de cellules solaires munies de moyens de concentration d'énergie lumineuse ne fournissent plus d'énergie électrique.

La figure 3i illustre une aile de générateur solaire GS munie de cinq panneaux solaires agencés en forme de T dont la base est du côté de l'aile attachée au satellite.

Deux panneaux PAC sont munis exclusivement de cellules solaires munies de moyens de concentration d'énergie lumineuse, et sont disposés aux extrémités de la barre horizontale du T. Les trois autres panneaux solaires PSC sont munis exclusivement de cellules solaires dépourvues de moyens de concentration d'énergie lumineuse.

Durant une phase avec dépointage, une telle aile de générateur solaire fournit ainsi deux cinquième d'énergie électrique en moins, car les deux panneau solaires PAC munis exclusivement de cellules solaires munies de moyens de concentration d'énergie lumineuse ne fournissent plus d'énergie électrique.

La figure 3j illustre une aile de générateur solaire GS munie de cinq panneaux solaires agencés en forme de T dont la base est du côté de l'aile attachée au satellite.

Trois panneaux PAC sont munis exclusivement de cellules solaires munies de moyens de concentration d'énergie lumineuse, et sont disposés sur la barre verticale du T. Les deux autres panneaux solaires PSC sont munis exclusivement de cellules solaires dépourvues de moyens de concentration d'énergie lumineuse.

Durant une phase avec dépointage, une telle aile de générateur solaire fournit ainsi trois cinquièmes d'énergie électrique en moins, car les trois panneaux solaires PAC munis exclusivement de cellules solaires munies de moyens de concentration d'énergie lumineuse ne fournissent plus d'énergie électrique.

La figure 3k illustre une aile de générateur solaire GS munie de cinq panneaux solaires agencés en forme de T dont la base est du côté de l'aile attachée au satellite.

Un panneau solaire PSC est muni exclusivement de cellules solaires dépourvues de moyens de concentration d'énergie lumineuse, et est disposé au milieu de la barre horizontale du T.

Les quatre panneaux PAC sont munis exclusivement de cellules solaires munies de moyens de concentration d'énergie lumineuse

Durant une phase avec dépointage, une telle aile de générateur solaire fournit ainsi quatre cinquième d'énergie électrique en moins, car les quatre panneaux solaires PAC munis exclusivement de cellules solaires munies de moyens de concentration d'énergie lumineuse ne fournissent plus d'énergie électrique.

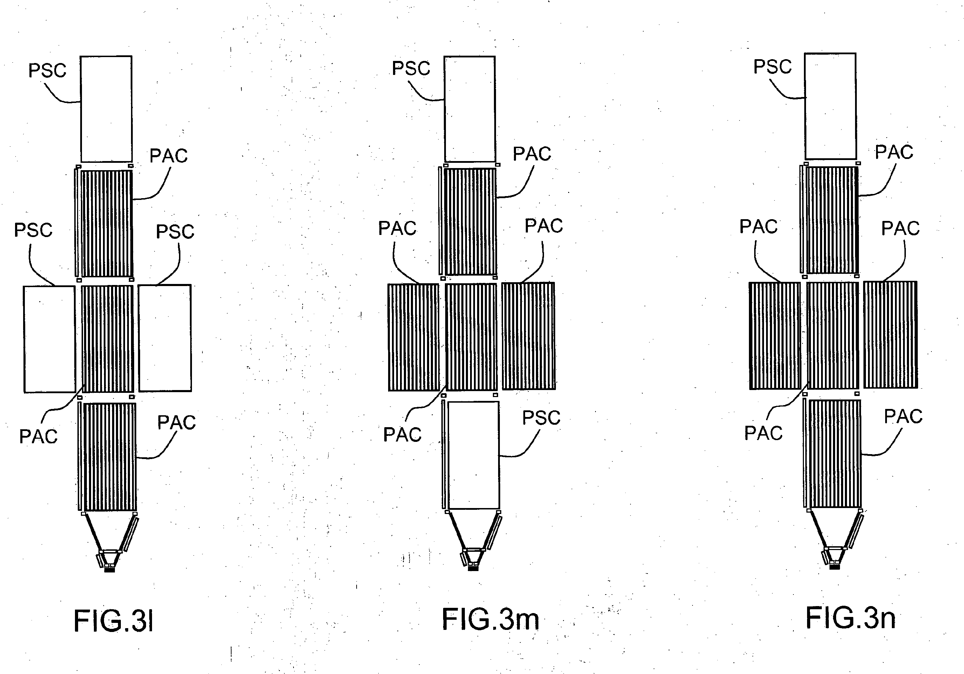

La figure 3l illustre une aile de générateur solaire GS munie de six panneaux solaires agencés en forme de croix dont la base est du côté de l'aile attachée au satellite.

Trois panneaux solaires PAC sont munis exclusivement de cellules solaires munies de moyens de concentration d'énergie lumineuse, et sont disposés sur la partie haute de la barre verticale de la croix.

Les trois autres panneaux PSC sont munis exclusivement de cellules solaires dépourvues de moyens de concentration d'énergie lumineuse.

Durant une phase avec dépointage, une telle aile de générateur solaire fournit ainsi la moitié d'énergie électrique en moins, car les trois panneaux solaires PAC munis exclusivement de cellules solaires munies de moyens de concentration d'énergie lumineuse ne fournissent plus d'énergie électrique.

La figure 3m illustre une aile de générateur solaire GS munie de six panneaux solaires agencés en forme de croix dont la base est du côté de l'aile attachée au satellite.

Quatre panneaux solaires PAC sont munis exclusivement de cellules solaires munies de moyens de concentration d'énergie lumineuse, dont trois forment la barre horizontale de la croix et le quatrième est disposé en dessous sur la barre verticale de la croix.

Les deux autres panneaux PSC sont munis exclusivement de cellules solaires dépourvues de moyens de concentration d'énergie lumineuse.

Durant une phase avec dépointage, une telle aile de générateur solaire fournit ainsi deux tiers d'énergie électrique en moins, car les quatre panneaux solaires PAC munis exclusivement de cellules solaires munies de moyens de concentration d'énergie lumineuse ne fournissent plus d'énergie électrique.

La figure 3n illustre une aile de générateur solaire GS munie de six panneaux solaires agencés en forme de croix dont la base est du côté de l'aile attachée au satellite.

Cinq panneaux solaires PAC sont munis exclusivement de cellules solaires munies de moyens de concentration d'énergie lumineuse, dont trois forment la barre horizontale de la croix, le quatrième est disposé en dessous sur la barre verticale de la croix et le cinquième est disposé au dessus sur la barre verticale de la croix.

L' autre panneau PSC est muni exclusivement de cellules solaires dépourvues de moyens de concentration d'énergie lumineuse.

Durant une phase avec dépointage, une telle aile de générateur solaire fournit ainsi cinq sixièmes d'énergie électrique en moins, car les cinq panneaux solaires PAC munis exclusivement de cellules solaires munies de moyens de concentration d'énergie lumineuse ne fournissent plus d'énergie électrique.

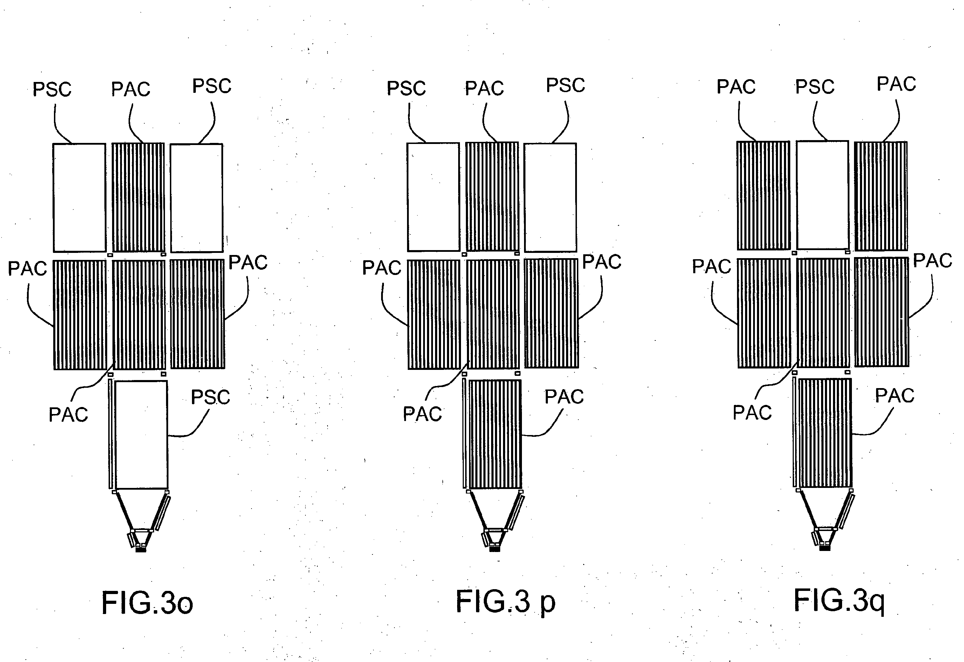

La figure 3o illustre une aile de générateur solaire GS munie de sept panneaux solaires agencés de sorte que trois panneaux soit reliée de manière linéaire, et que les deux panneaux terminant cette liaison de trois panneaux, dont la base est du côté de l'aile attachée au satellite, sont respectivement encadrés par deux panneaux.

Quatre panneaux solaires PAC sont munis exclusivement de cellules solaires munies de moyens de concentration d'énergie lumineuse, dont deux terminent la liaison linéaire, et deux autres encadrent le panneau du milieu de la liaison linéaire.

Les trois autres panneaux PSC sont munis exclusivement de cellules solaires dépourvues de moyens de concentration d'énergie lumineuse.

Durant une phase avec dépointage, une telle aile de générateur solaire fournit ainsi quatre septièmes d'énergie électrique en moins, car les cinq panneaux solaires PAC munis exclusivement de cellules solaires munies de moyens de concentration d'énergie lumineuse ne fournissent plus d'énergie électrique.

La figure 3p illustre une aile de générateur solaire GS munie de sept panneaux solaires agencés de sorte que trois panneaux soit reliée de manière linéaire, et que les deux panneaux terminant cette liaison de trois panneaux, dont la base est du côté de l'aile attachée au satellite, sont respectivement encadrés par deux panneaux.

Cinq panneaux solaires PAC sont munis exclusivement de cellules solaires munies de moyens de concentration d'énergie lumineuse, dont trois forment la liaison linéaire, et deux autres encadrent le panneau du milieu de la liaison linéaire.

Les deux autres panneaux PSC sont munis exclusivement de cellules solaires dépourvues de moyens de concentration d'énergie lumineuse.

Durant une phase avec dépointage, une telle aile de générateur solaire fournit ainsi cinq septièmes d'énergie électrique en moins, car les cinq panneaux solaires PAC munis exclusivement de cellules solaires munies de moyens de concentration d'énergie lumineuse ne fournissent plus d'énergie électrique.

La figure 3q illustre une aile de générateur solaire GS munie de sept panneaux solaires agencés de sorte que trois panneaux soit reliée de manière linéaire, et que les deux panneaux terminant cette liaison de trois panneaux, dont la base est du côté de l'aile attachée au satellite, sont respectivement encadrés par deux panneaux.

Six panneaux solaires PAC sont munis exclusivement de cellules solaires munies de moyens de concentration d'énergie lumineuse, dont deux commencent la liaison linéaire, et les quatre autres sont les autres panneaux ne faisant pas partie de la liaison linéaire.

Le panneau PSC est muni exclusivement de cellules solaires dépourvues de moyens de concentration d'énergie lumineuse.

Durant une phase avec dépointage, une telle aile de générateur solaire fournit ainsi six septièmes d'énergie électrique en moins, car les cinq panneaux solaires PAC munis exclusivement de cellules solaires munies de moyens de concentration d'énergie lumineuse ne fournissent plus d'énergie électrique.

Ainsi, les différents modes de réalisation, permettent selon les caractéristiques et besoins du satellite, de prévoir un générateur solaire permettant de fournir suffisamment d'énergie électrique même durant une phase de dépointage.

## Revendications

1. Engin spatial comprenant un ensemble hybride d'au moins un panneau solaire, ledit ensemble comprend au moins une cellule solaire (CSC) munie de moyens de concentration (Conc) d'énergie lumineuse, **caractérisé en ce que** ledit ensemble comprend en outre au moins une cellule solaire dépourvue de moyens de concentration d'énergie lumineuse.

2. Engin spatial selon la revendication 1, dans lequel lesdits moyens de concentration (Conc) d'énergie lumineuse comprennent au moins un réflecteur (Ref).

3. Engin spatial selon la revendication 1, dans lequel lesdits moyens de concentration (Conc) d'énergie lumineuse comprennent au moins un concentrateur.

4. Engin spatial selon la revendication 3, dans lequel ledit concentrateur comprend au moins une lentille optique (Lent).

5. Engin spatial selon la revendication 4, dans lequel ladite lentille (Lent) est une lentille de Fresnel et comprend au moins une partie en matériau souple pliable, et un dispositif de déploiement de ladite lentille (Lent).

6. Engin spatial selon l'une des revendications précédentes, comprenant au moins un panneau solaire (PAC) muni exclusivement de cellules solaires munies de moyens de concentration d'énergie lumineuse, et au moins un panneau solaire (PSC) muni exclusivement de cellules solaires dépourvues de moyens de concentration (Conc) d'énergie lumineuse.

7. Procédé de génération d'énergie électrique pour engin spatial par hybridation d'énergie électrique générée par au moins une cellule solaire (CSC) munie de moyens de concentration (Conc) d'énergie lumineuse, et au moins une cellule solaire dépourvue de moyens de concentration d'énergie lumineuse.

## Patentansprüche

1. Raumfahrzeug, das eine Hybridbaugruppe mit wenigstens einer Solarplatte umfasst, wobei die Baugruppe wenigstens eine Solarzelle (CSC) umfasst, die mit Mitteln zum Konzentrieren (Conc) von Lichtenergie ausgestattet ist, **dadurch gekennzeichnet, dass** die Baugruppe darüber hinaus wenigstens eine Solarzelle ohne Lichtenergiekonzentrationsmittel aufweist.

2. Raumfahrzeug nach Anspruch 1, bei dem die Lichtenergiekonzentrationsmittel (Conc) wenigstens einen Reflektor (Ref) umfassen.

3. Raumfahrzeug nach Anspruch 1, bei dem die Lichtenergiekonzentrationsmittel (Conc) wenigstens einen Konzentrator umfassen.

4. Raumfahrzeug nach Anspruch 3, bei dem der Konzentrator wenigstens eine optische Linse (Lent) umfasst.

5. Raumfahrzeug nach Anspruch 4, bei dem die Linse (Lent) eine Fresnel-Linse ist und wenigstens einen Teil aus einem faltbaren elastischen Material umfasst, und eine Vorrichtung zum Entfalten der Linse (Lent).

6. Raumfahrzeug nach einem der vorherigen Ansprüche, das wenigstens eine Solarplatte (PAC) umfasst, die ausschließlich mit Solarzellen ausgestattet ist, die Lichtenergiekonzentrationsmittel aufweisen, und wenigstens eine Solarplatte (PSC), die ausschließlich mit Solarplatten ohne Lichtenergiekonzentrationsmittel (Conc) ausgestattet ist.

7. Verfahren zum Erzeugen von elektrischer Energie für ein Raumfahrzeug durch Hybridisieren von elektrischer Energie, die von wenigstens einer Solarplatte (CSC) erzeugt wurde, die mit Lichtenergiekonzentrationsmitteln (Conc) ausgestattet ist, und wenigstens einer Solarzelle, die nicht mit Lichtenergiekonzentrationsmitteln ausgestattet ist.

## Claims

1. A spacecraft comprising a hybrid assembly of at least one solar panel, said assembly comprising at least one solar cell (CSC) provided with light energy concentration means (Conc), **characterised in that** said assembly further comprises at least one solar cell without light energy concentration means.

2. The spacecraft according to claim 1, wherein said light energy concentration means (Conc) comprise at least one reflector (Ref).

3. The spacecraft according to claim 1, wherein said light energy concentration means (Conc) comprise at least one concentrator.

4. The spacecraft according to claim 3, wherein said concentrator comprises at least one optical lens (Lent).

5. The spacecraft according to claim 4, wherein said lens (Lent) is a Fresnel lens and comprises at least one part in a pliable flexible material and a device for deploying said lens (Lent).

6. The spacecraft according to any one of the preceding claims, comprising at least one solar panel (PAC) solely provided with solar cells provided with light energy concentration means and at least one solar panel (PSC) solely provided with solar cells without light energy concentration means (Conc).

7. A method for generating electric energy for spacecraft by the hybridisation of electric energy generated by at least one solar cell (CSC) provided with light energy concentration means (Conc) and at least one solar cell without light energy concentration means.
